# EUROPÄISCHE PATENTSCHRIFT

(11) **EP 2 733 756 B1**
(45) Veröffentlichungstag und Bekanntmachung des Hinweises auf die Patenterteilung: **03.05.2017**
(21) Anmeldenummer: 13005141.0
(22) Anmeldetag: 30.10.2013
(51) Int. Cl.: H01L 35/30, H01L 35/32

(54) **Verfahren zur Umwandlung von Wärme in elektrische Energie**
Method for converting heat to electrical energy
Procédé de transformation de chaleur en énergie électrique

(30) Priorität: 20.11.2012 DE 102012022863
(43) Veröffentlichungstag der Anmeldung: 21.05.2014
(73) Patentinhaber: Astrium GmbH, 82024 Taufkirchen (DE)
(72) Erfinder: Sebald, Johannes, 27721 Ritterhude (DE); Kesuma, Hendra, 28277 Bremen (DE)
(74) Vertreter: Marschall, Stefan

(56) Entgegenhaltungen:
- WO-A1-2008/000018
- WO-A2-2012/064595
- DE-A1- 10 151 072
- US-A- 3 053 923
- US-A1- 2010 186 794

## Beschreibung

Die Erfindung betrifft ein Verfahren zur direkten Umwandlung von Wärme in elektrische Energie mittels wenigstens eines thermoelektrischen Generatormoduls, wobei die Wärmestrahlung einer Wärmequelle mittels des thermoelektrischen Generatormoduls gesammelt und zu einem Kühlkörper geführt wird. Ferner betrifft sie eine Vorrichtung zur Durchführung dieses Verfahrens.

Vorrichtungen zur direktem Umwandlung von Wärme in elektrische Energie, die auch als thermoelektrische Generatoren (TEG) bekannt sind, wandeln Wärme bzw. eine Temperaturdifferenz mittels des sogenannten "Seebeck-Effektes" oder "thermoelektrischen Effektes" direkt in elektrische Energie um. Ihr Wirkungsgrad liegt dabei typischerweise in der Größenordnung von etwa 5 Prozent. Neuere Entwicklungen zu diesem Thema sind beispielsweise im Internet unter dem Link "http://www.electrochem.org/dl/interface/fal/fal08/fal08_p54-56.pdf" zu finden. Thermoelektrische Generatoren bzw. Wandler finden unter anderem bereits in Isotopenbatterien (Radioisotope Thermoelectric Generator, RTG) Anwendung und wandeln verschleißfrei und ohne bewegte Teile Wärmeenergie direkt in elektrische Energie. Durch den Einsatz von Halbleitermaterialien läßt sich der Umwandlungswirkungsgrad zwar auf 3 bis 8 % steigern, er liegt aber auch bei den derzeit bereits verwendeten neuen Materialien noch deutlich unter dem Carnot-Wirkungsgrad. Zurzeit ist man bestrebt, solche thermoelektrischen Generatoren auch zur Nutzung von Abwärme, beispielsweise in Kraftfahrzeugen, Blockheizkraftwerken, Abwasseranlagen oder Müllverbrennungsanlagen einzusetzen.

Der Einsatz thermoelektrischer Generatoren, die zur Gewinnung von Energie im direkten Kontakt mit der Wärmequelle stehen, kann allerdings auch zu Problemen führen. So ist eine sehr hohe Temperatur der Wärmequelle, die beispielsweise 3400 Grad Celsius betragen kann, nur bis zu einer maximalen Temperatur von derzeit etwa 450 Grad Celsius der auf dem Markt erhältlichen thermoelektrischen Generatoren beherrschbar.

Aus der US 3 510 363 A, ist ein Verfahren der eingangs genannten Art bekannt geworden, bei dem ein thermoelektrischer Generator auch in Satelliten eingesetzt werden kann, indem er im Inneren einer geschlossenen, mit einem Inertgas gefüllten Kapsel angeordnet wird, in der sich eine geeignete Wärmequelle befindet. Insbesondere handelt es sich bei dem bei dem in diesem bekannten Fall verwendeten thermoelektrischen Generator um einen RTG, einen Radioisotope Thermoelectric Generator, der die durch einen radioaktiven Zerfall entstehende Wärme für seine Funktion nutzt und bei dem die Wärmestrahlung neben der Wärmeleitung einen Teil des Wärmetransportvorganges bildet.

Daneben ist auch aus der US 3 666 566 A eine Anordnung mit einem Radioisotopen Thermoelektrischen Generator bekannt geworden, bei dem die Wärmeübertragung mittels eines Mediums und Wärmeleitung bzw. latenter Wärme/Phasenübergängen erfolgt. Weiterhin ist auch aus der US 2006/0 021 648 A1 eine ähnliche Anordnung bekannt geworden. Weiterhin offenbart US 3 053 923 ein Verfahren und eine Vorrichtung zum Einsatz im Weltraum zum Umwandeln von Sonnenenergie mittels eines thermoelektrischen Generatormoduls. Schließlich ist in der DE 10 2008 031 266 A1 eine Generatoroberfläche beschrieben, die eine möglichst verzögerungsarme Anpassung der Generatoroberflächentemperatur an die Umgebungstemperatur bewirken soll, während eine zweite der Generatoroberflächen mit Mitteln vorgesehen ist, die eine möglichst verzögerte Anpassung der Generatoroberflächentemperatur an die Umgebungstemperatur bewirken sollen. Dadurch soll ein transienter Betrieb eines solchen thermoelektrischen Generators ermöglicht werden.

Erste Aufgabe der Erfindung ist es, ein Verfahren der eingangs genannten Art so auszubilden, dass es auch unter Vakuumbedindungen im Weltraum einsetzbar ist. Weiterhin soll durch die Erfindung eine Vorrichtung zur Durchführung eines solchen Verfahrens bereitgestellt werden.

Die Erfindung löst die erste Aufgabe dadurch, dass bei einem derartigen Verfahren thermische Strahlung in das Vakuum eines Raumes abgegeben und durch das Vakuum hindurch mittels Strahlungskopplung entweder zu einem Kühlkörper geführt oder aber direkt in das umgebende Weltraumvakuum abgestrahlt wird.

Die Lösung der weiteren Aufgabe erfolgt gemäß der Erfindung dadurch, dass wenigstens ein thermoelektrisches Generatormodul in der Nähe einer Wärmequelle im Inneren eines mit Vakuum erfüllten Raumes angeordnet ist, dessen Wand zumindest teilweise als Kühlkörper ausgebildet ist, und wobei das thermoelektrische Generatormodul durch Strahlungskopplung mit der Wärmequelle verbunden ist.

Bei der Verwendung eines solchen thermoelektrischen Generatormoduls im Inneren eines evakuierten Raumes, dessen Wand zumindest teilweise als Kühlkörper ausgebildet ist, ergeben sich eine Reihe von Vorteilen:
- Das thermoelektrische Generatormodul ist in der Umgebung der Wärmequelle - falls erforderlich - an einem wärmeleitenden Körper, in diesem Fall einer zumindest teilweise als Kühlkörper ausgebildeten Wand, flexibel platzierbar.
- Statt eines direkten mechanischen Kontakts mit der Wärmequelle kann das erfindungsgemäß verwendete thermoelektrische Generatormodul infolge der auch im Vakuum wirksamen Strahlungskopplung auf eine direkte mechanische Anbindung verzichten.
- Das thermoelektrische Generatormodul kann die Wärme entweder an den wärmeleitenden Körper abgeben oder aber in das umgebende Weltraumvakuum abstrahlen, wodurch eine zusätzliche Kühlung der gesamten Anordnung entfallen kann.

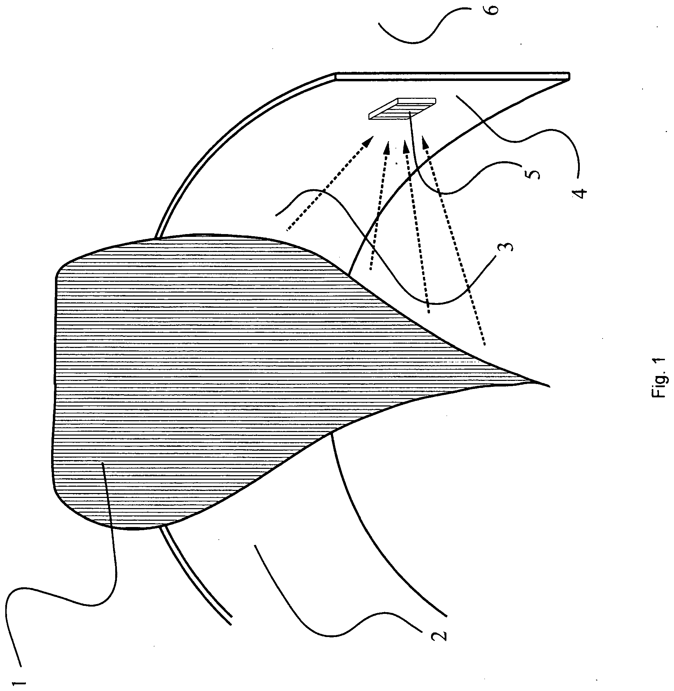

Nachfolgend soll die Erfindung anhand eines in der Zeichnung dargestellten Ausführungsbeispiels näher erläutert werden. Die Abbildung zeigt eine Vorrichtung zur direktem Umwandlung von Wärme in elektrische Energie bei Weltraummissionen mittels eines thermoelektrischen Generators.

Eine Wärmequelle 1 gibt thermische Strahlung 3 in das Vakuum 2 eines Raumes ab. Wenigstens ein thermoelektrisches Generatormodul 5 leitet diese Wärme an einen wärmeleitenden Körper 4, im Fall des hier dargestellten Ausführungsbeispiels an eine Wand, die zumindest teilweise als Kühlkörper ausgebildet ist, weiter oder aber es gibt diese Wärme direkt an das umgebende Weltraumvakuum 6 ab.

## Patentansprüche

1. Verfahren zur direkten Umwandlung von Wärme in elektrische Energie mittels wenigstens eines thermoelektrischen Generatormoduls unter Vakuumbedingungen im Weltraum, wobei die Wärmestrahlung (3) einer Wärmequelle (1) mittels des thermoelektrischen Generatormoduls (5) gesammelt wird, **dadurch gekennzeichnet, dass** das wenigstens eine thermoelektrische Generatormodul in der Nähe einer Wärmequelle im Inneren eines mit Vakuum erfüllten Raumes angeordnet ist, wobei thermische Strahlung (3) in das Vakuum (2) des Raumes abgegeben und durch das Vakuum (2) hindurch mittels Strahlungskopplung entweder zu einem Kühlkörper (4) geführt oder aber direkt in das umgebende Weltraumvakuum (6) abgestrahlt wird.

2. Vorrichtung zur Durchführung des Verfahrens gemäß Anspruch 1, **dadurch gekennzeichnet, dass** wenigstens ein thermoelektrisches Generatormodul (5) in der Nähe einer Wärmequelle (1) im Inneren eines mit Vakuum (2) erfüllten Raumes angeordnet ist, dessen Wand zumindest teilweise als Kühlkörper (4) ausgebildet ist, und wobei das thermoelektrische Generatormodul (5) durch Strahlungskopplung mit der Wärmequelle (1) verbunden ist.

3. Vorrichtung nach Anspruch 2, **dadurch gekennzeichnet, daß** mehrere thermoelektrische Generatormodule (5) vorgesehen sind.

## Claims

1. A method for the direct conversion of heat into electrical energy by means of at least one thermoelectric generator module under vacuum conditions in space, wherein the thermal radiation (3) of a heat source (1) is collected by means of the thermoelectric generator module (5), **characterised in that** the at least one thermoelectric generator module is arranged in the vicinity of a heat source inside a chamber filled with a vacuum, wherein thermal radiation (3) is emitted into the vacuum (2) of the chamber and conveyed through the vacuum (2) by means of radiation coupling either to a heat sink (4) or is released directly into the surrounding vacuum (6) of space.

2. A device for performing the method according to claim 1, **characterised in that** the at least one thermoelectric generator module (5) is arranged in the vicinity of a heat source (1) inside a chamber filled with a vacuum (2), the wall whereof is constituted at least partially as a heat sink (4), and wherein the thermoelectric generator module (5) is connected by radiation coupling to the heat source (1).

3. The device according to claim 2, **characterised in that** a plurality of thermoelectric generator modules (5) are provided.

## Revendications

1. Procédé destiné à transformer directement de la chaleur en énergie électrique au moyen d'au moins un module générateur thermoélectrique dans des conditions sous vide dans l'espace interplanétaire, lors duquel on collecte le rayonnement thermique (3) d'une source de chaleur (1) au moyen du module générateur (5), **caractérisé en ce que** l'au moins un module générateur thermoélectrique est disposé à proximité d'une source de chaleur à l'intérieur d'un local placé sous vide, un rayonnement thermique (3) étant distribué dans le vide (2) du local et en traversant le vide (2), étant conduit au moyen d'un couplage du rayonnement soit vers un dissipateur thermique (4) ou alors étant directement émis dans le vide interplanétaire (6) environnant.

2. Dispositif destiné à réaliser le procédé selon la revendication 1, **caractérisé en ce que** l'au moins un module générateur (5) thermoélectrique est disposé à proximité d'une source de chaleur (1) à l'intérieur d'un local placé sous vide (2) dont la paroi est conçue au moins partiellement en tant que dissipateur thermique (4) et le module générateur thermoélectrique (5) étant relié par couplage de rayonnement avec la source de chaleur (1).

3. Dispositif selon la revendication 2, **caractérisé en ce que** plusieurs modules générateurs (5) thermoélectriques sont prévus.
